# EUROPEAN PATENT APPLICATION

(11) **EP 1 418 251 A1**
(43) Date of publication of application: **12.05.2004**
(21) Application number: 03255295.2
(22) Date of filing: 26.08.2003
(51) Int. Cl.: C23C 18/42, H05K 3/18, H05K 3/24

(54) **Plating method**

(30) Priority: 30.08.2002 US 407107 P; 16.07.2003 US 620916
(71) Applicant: Shipley Company LLC, Marlborough, MA 01752 (US)
(72) Inventor: Rzeznik, Maria Anna, Framingham, Massachusetts 01702 (US); Jacques, David L., Northbridge, Massachusetts 01534 (US)
(74) Representative: Kent, Venetia Katherine

(57) **Abstract**

The present invention provides compositions and methods for immersion depositing highly adherent silver layers. The compositions contain silver ions, water and a carboxylic acid-substituted nitrogen-containing heterocyclic compound. Such compositions and methods are particularly useful in the manufacture of electronic devices.

## Description

### Background of the Invention

The present invention relates generally to the field of metal plating. In particular, the present invention relates to the field of immersion silver plating.

Immersion or displacement plating is an electroless plating process, but is given a separate classification in the art. In immersion plating, deposition is by displacement of an elemental metal from a substrate by metal ions in a plating solution. In electroless plating deposition takes place primarily by autocatalytic reduction of metal ions from solution. Such electroless plating requires the presence of a reducing agent.

Immersion plating does not employ an external electric current but rather is an electrochemical displacement reaction which is driven by the position of the substrate metal in the electromotive series relative to the metal to be deposited from solution. Plating occurs when the dissolved metal ions in a plating bath are displaced by a more active (less noble) metal that is contacted with the plating bath.

In the manufacture of printed wiring boards, solderable finishes are typically applied to printed wiring board substrates having pads and/or through holes exposed through a mask, such as a soldermask. Such solderable finishes are often applied by immersion plating as electroless plating can also deposit metal on the surface of the mask, which is undesirable. As an immersion plating reaction is driven by the difference in electrochemical potentials, plating will only occur at areas of exposed metal. However, there is a growing demand for more environmentally acceptable alternatives to lead for use in printed wiring board manufacture. Thus, the use of lead and lead alloys in electronic components faces an uncertain future.

Silver is a more environmentally acceptable alternative to lead and has been suggested for use as a solderable finish. As discussed above, the preferred method of depositing such a solderable finish is by immersion plating. For example, U.S. Patent No. 5,955,141 (Souter et al.) discloses certain immersion silver plating baths suitable for depositing a layer of silver on a printed wiring board.

Limitations on the use of immersion plating exist in printed wiring board manufacture. Such limitations include relatively slow plating rates and limited deposit thicknesses, which are due to the self-limiting nature of immersion plating, i.e. as the metal deposit builds, it tends to mask the underlying base metal, thereby preventing further displacement. These problems have conventionally been addressed using a broad range of additives in the immersion plating bath, such as rate enhancers. However, such additives may adversely affect other important characteristics of the deposit, such as adhesion and deposit uniformity.

Therefore, there is a need for a method of improving the adhesion of immersion plated silver deposits. There is a further need for methods that do not adversely affect other important characteristics of the silver deposit obtained from immersion plating baths.

Picolinic acid has been used in a tarnish remover composition for silver and copper, see Indian Patent No 163677. Zhuang et al., Huaxue Xuebao, 1985, vol. 43, no. 2, pp 120-125, disclose the electrodeposition of silver from a plating bath containing silver nitrate, ammonia and pyridine carboxylic acid. This article does not disclose the use of picolinic acid in an immersion silver plating bath.

### Summary of the Invention

It has been surprisingly found that an electroless, particularly an immersion, silver plating bath containing as a complexing agent one or more carboxylic acid-substituted nitrogen-containing heterocyclic compounds provides a subsequently immersion deposited layer of silver having improved adhesion as compared to silver deposits obtained from conventional immersion deposition methods without such a complexing agent. In addition, bright silver deposits are obtained using these plating baths.

The present invention provides a method of depositing a layer of silver on a substrate including the step of contacting a substrate having a layer of a metal that is less electropositive than silver with an immersion silver plating bath including one or more sources of silver ions, water and one or more carboxylic acid-substituted nitrogen-containing heterocyclic compounds, wherein the silver plating bath has a pH of less than or equal to 4.

Also provided by the present invention is a method of manufacturing a printed wiring board including the step of contacting a printed wiring board substrate having a layer of a metal that is less electropositive than silver with an immersion silver plating bath including one or more sources of silver ions, water and one or more carboxylic acid-substituted nitrogen-containing heterocyclic compounds, wherein the silver plating bath has a pH of less than or equal to 4.

The present invention further provides an immersion silver plating bath including one or more sources of silver ions, water and one or more carboxylic acid-substituted nitrogen-containing heterocyclic compounds. Such compositions are typically free of ammonia and free of cyanide. The present plating baths may further contain one or more thickness control agents.

### Detailed Description of the Invention

As used throughout this specification, the following abbreviations shall have the following meanings, unless the context clearly indicates otherwise: ° C = degrees centigrade; ca. = circa = approximately; g = gram; L = liter; g/L = grams per liter; mL = milliliters; wt% = percent by weight; DI = deionized; cm = centimeters; µin. = microinches; and µm = microns = micrometers (1 µin. = 0.0254 µm).

The terms "printed circuit board" and "printed wiring board" are used interchangeably throughout this specification. As used throughout this specification, the term "complexing agent" includes ligands and chelating agents. Unless otherwise noted, all amounts are percent by weight and all ratios are by weight. All numerical ranges are inclusive and combinable in any order, except where it is clear that such numerical ranges are constrained to add up to 100%.

The present invention provides a method of improving the adhesion of a layer of silver deposited from an immersion plating bath including the step of contacting a metal that is less electropositive than silver with a bath containing one or more sources of silver ions, water one or more carboxylic acid-substituted nitrogen-containing heterocyclic compounds, wherein the silver plating bath has a pH of less than or equal to 4. The present invention provides a layer of silver deposited from an immersion plating bath having increased adhesion as compared to a layer of silver deposited using a conventional immersion silver plating bath. Thus, more adherent silver deposits are obtained, which are less likely to flake or abrade off than conventional immersion silver deposits. The increased adhesion of silver deposits obtained according to the present invention also provides better surface mount connections between a printed wiring board and a surface mount device. In addition, the silver deposits obtained from the present plating baths are bright.

Any water soluble silver salt may be used as the source of silver ions in the present plating baths. Suitable silver salts include, but are not limited to, silver nitrate, silver acetate, silver sulfate, silver lactate, and silver formate. Typically, the source of silver ions is silver nitrate. Mixtures of silver salts may also be used. The one or more sources of silver ions are typically present in an amount sufficient to provide silver ions in solution in a concentration of from 0.06 to 32 g/L, more typically from 0.1 to 25 g/L and still more typically from 0.5 to 15 g/L.

Carboxylic acid-substituted nitrogen-containing heterocyclic compounds function as both complexing agents and adhesion promoters. By "carboxylic acid-substituted nitrogen-containing hetrocylic compound" is meant any nitrogen-containing heterocyclic moiety having one or more of its hydrogens replaced by one or more carboxylic acid groups (-CO₂H). A wide variety of nitrogen-containing heterocyclic moieties may be used, such as, but not limited to, pyridine, piperidine, piperazine, morpholine, pyrrole, pyrrolidine, triazole, and imidazole. Such heterocyclic compounds may be fused to another ring such as benzotriazole, benzimidazole, quinoline or isoquinoline, or may be further substituted, or both. Suitable substitutent groups include without limitation hydroxy, (C₁-C₁₀)alkyl, (C₁-C₁₀)alkoxy, and halo. Exemplary carboxylic acid-substituted nitrogen containing heterocyclic compounds include, but are not limited to, pyridine carboxylic acids, pyridine dicarboxylic acids, piperidine carboxylic acids, piperazine carboxylic acids, and pyrrole carboxylic acids. The pyridine carboxylic acids are particularly useful, such as picolinic acid, quonolinic acid, nicotinic acid and fusaric acid. Such compounds are generally commercially available, such as from Sigma-Aldrich (Milwaukee, Wisconsin), or may be prepared by methods known in the literature. The carboxylic acid-substituted nitrogen-containing compound may be used in a variety of concentrations but is typically present in the immersion silver plating baths either in stoichiometrically equivalent amounts (based on the amount of silver ion) or in a stoichiometric excess so that all the silver ions may be complexed. The term "stoichiometric" as used herein refers to equimolar. Preferably, the one or more complexing agents are present in a higher molar concentration than the silver ions. The molar ratio of the complexing agent to silver ions is generally > 1: 1, and typically ≥1.2: 1, more typically ≥ 2.0:1, and still more typically ≥ 3.0: 1. In general, the total amount of the one or more complexing agents is typically from 0.1 to 250 g/L, and particularly from 15 to 220 g/L, more particularly from 25 to 200 g/L, and still more particularly from 40 to 150 g/L.

It will be appreciated by those skilled in the art that more than one carboxylic acid-substituted nitrogen-containing heterocyclic compound may be used. One or more other complexing agents, i.e. any complexing agent that is not a carboxylic acid-substituted nitrogen-containing heterocyclic compound, may also be added to the present plating baths.

The pH of the present plating baths is typically less than or equal to 4. Baths having higher pH values may be used, however, the resulting silver deposit may be significantly thinner. Preferably, the pH of the bath is < 4. A particularly useful pH range is from 3 to 4. Other useful plating baths have a pH < 3, such as a pH in the range of 2 to 3. A buffering agent may be added to maintain the pH of the bath at the desired value. Any compatible acids or bases may be used as the buffering agents and may be organic or inorganic. By "compatible" acids or bases it is meant that the acids or bases do not result in precipitation of the silver ions and/or complexing agents(s) from solution, when such acids or bases are used in amounts sufficient to buffer the pH. Exemplary buffering agents include, without limitation, citric acid, tartaric acid, nitric acid, acetic acid and phosphoric acid.

The immersion silver plating baths may optionally contain one or more additional components. Suitable additional components include, but are not limited to, surfactants or wetting agents, anti-tarnish agents for silver, oxidation inhibitors, levelers, grain refiners, thickness controllers, defoamers, dyes, and the like. When surfactants are used in the present immersion baths, they are typically used in an amount of from 0.02 to 100 g/L, more typically from 0.1 to 25 g/L, and even more typically from 1 to 15 g/L. Such surfactants may be anionic, cationic, nonionic or amphoteric. The choice of surfactant will depend upon the particular immersion silver plating bath used. When surfactants are present, nonionic surfactants are preferred.

A wide variety of anti-tarnish agents for silver may be used, such as triazoles, tetrazoles, and imidazoles. Such anti-tarnish agents are well known to those skilled in the art. The anti-tarnish agents may be used in an amount from 0.001 to 50 g/L, more typically from 0.005 to 25 g/L, and still more typically from 0.01 to 10 g/L.

Grain refiners are typically added to improve the appearance of the silver deposit. Exemplary grain refiners include, without limitation, (C₁-C₆)alcohols and polyalkylene glycols such as polyethylene glycol. Such grain refiners are typically used in an amount from 0.02 to 200 g/L, and more typically from 0.05 to 100 g/L.

Deposit thickness may be controlled by the addition of one or more thickness control agents. Any agent suitable for controlling the thickness of an immersion silver deposit may be added to the present plating baths. Such thickness control agents include rate enhancers and rate inhibitors. Suitable rate enhancers include, but are not limited to: amino acids such as glycine, DL-lysine, β-alanine, glutamic acid and DL-aspartic acid; sulfur-containing compounds such as mercaptodiacetic acid; hydroxy-substituted aromatic compounds such as 5-methoxyresorcinol; and azoles such as imidazole, 2-imidazolidone and 2,4-imidazolidinedione. Suitable rate inhibitors include, without limitation: azoles such as imidazole, 4-phenylimidazole, 1,2,4-triazolo[1,5-a]pyrimidine, 4-amino-1,2,4-triazole and 2-imidazolidone; and hydroxy-substituted aromatic compounds such as 5-methoxyresorcinol. Suitable thickness control agents are the azoles, amino acids and the sulfur-containing compounds. Particularly useful thickness control agents are glycine, DL-lysine, mercaptodiacetic acid and 1,2,4-triazolo[1,5-ajpynmidine. It will be appreciated by those skilled in the art that mixtures of thickness control agents can be used. Such mixtures can contain two or more rate enhancers, two or more rate inhibitors or a combination of one or more rate inhibitors with one or more rate enhancers. Certain thickness control agents can function as a rate enhancer at one pH and as a rate inhibitor at another pH. Likewise, certain thickness control agents can function as a rate enhancer when present in the plating bath at one concentration and function as a rate inhibitor when present at a different concentration. Such behavior is well known to those skilled in the art or can be determined by simple experimentation. Suitable thickness control agents are generally commercially available such as from Sigma-Aldrich.

Typically, the thickness control agents may be present in the immersion silver plating baths in an amount from 0.01 to 10 g/L, more typically from 0.1 to 5 /L and still more typically from 0.5 to 3 g/L.

Preferably, the immersion silver baths are free of reducing agents capable of reducing silver ions. It is further preferred that the immersion silver baths are free of cyanide ions, ammonia and ammonium ions (i.e. NH₄⁺). More preferably, the present plating baths contain only one or more carboxylic acid-substituent nitrogen-containing heterocyclic compounds as complexing agents, although one or more other complexing agents may be used in combination with the nitrogen-containing heterocyclic compound depending upon the desired application.

The immersion silver baths are typically prepared by combining the above ingredients in any order. Preferably, the baths are prepared by forming a solution of complexing agent in water and adding the source of silver ions to this solution. The optional ingredients may be combined with the solution in any order.

The immersion silver plating baths may be agitated. Any form of agitation may be used. Suitable agitation includes, but is not limited to, stirring, shaking, swirling, aeration, sonication and the like. Stirring may be accomplished by any suitable means, such as with an overhead stirrer, paddle stirrer or stirring bar system. Shaking may be accomplished in a variety of ways, such as by moving the substrate to be silver plated back and forth or side to side within the plating bath. Aeration may be accomplished by bubbling or sparging a gas into the plating bath, or by means of jet spray. Sparging may be accomplished by bubbling gas into the bath through a fritted means, such as a tube having a frit composed of glass, poly(tetrafluoroethylene) or other inert material. Any gas may be used such as air, oxygen or an inert gas, and preferably air. In a particular embodiment, aeration is used to agitate the bath. Swirling may be accomplished by moving the bath or the substrate to be plated in a substantially circular motion. It will be appreciated by those skilled in the art that a combination of agitation methods may be employed, such as stirring with aeration.

Silver is deposited on any substrate having a metal layer that is less electropositive than silver by contacting the metal layer with the present plating baths. Such contact may be by a variety of means, such as dipping, spraying, flood coating, and the like. A particularly suitable method of contacting with the present compositions is spraying in a flood mode.

Suitable metals that are less electropositive than silver include, but are not limited to, zinc, iron, tin, nickel, lead, copper or alloys containing one or more of these metals. Particularly useful metals are tin, copper or alloys of tin or copper. A particularly suitable alloy is tin-copper. In an alternate embodiment, such metal may itself be immersion deposited on a suitable metal underlayer prior to depositing an immersion silver layer according to the present invention. For example, the metal may be tin, such tin deposit being first deposited, such as by immersion, electroless or electrolytic deposition, on copper.

Prior to silver plating, the metal to be plated is typically cleaned. Cleaning removes oxides and organic contaminants from the metal surface as well as resist residues that may remain from incomplete development of photoresists as well as soldermask residues from copper surfaces. Such cleaning may be by any suitable cleaning processes and/or products. For example, when the metal layer is copper or a copper alloy, it is preferred that the metal layer is cleaned with an acidic cleaning composition. Such cleaning procedures are well within the ability of one skilled in the art. After cleaning, the substrate is typically rinsed, such as with water, and optionally dried. The metal layer may be microetched either before or after the cleaning step, and typically after the cleaning step. Such microetching is accomplished by contacting the metal layer on the substrate with a microetching composition, such as sulfuric acid/hydrogen peroxide or an alkali metal persulfate such as sodium or potassium persulfate. When such a microetching step is used, the metal layer may then optionally be rinsed with water or an acid, such as with sulfuric acid, to remove any residues from the cleaning and/or microetching steps.

Optionally, the metal to be silver plated may be contacted with a pretreatment composition after cleaning and before contact with the silver plating bath. Any suitable pretreatment composition may be used. Preferred pretreatment compositions include one or more azole compounds, water and a chelating agent.

A wide variety of azole compounds may suitably be used in the pretreatment compositions. Suitable azoles include, but are not limited to, triazoles, benzotriazoles, tetrazoles, imidazoles, benzimidazoles, indazoles and mixtures thereof. Such azoles may optionally be substituted.

Particularly useful azole compounds are benzotriazole, substituted benzotriazole, imidazole and substituted imidazole, and more specifically benzotriazole, imidazole, (C₁-C₁₆)alkylimidazole, and arylimidazole. Phenylimidazole is the preferred arylimidazole. Exemplary (C₁-C₁₆)alkylimidazoles include methylimidazole, ethylimidazole, propylimidazole, hexylimidazole, decylimidazole and undecylimidazole. Such azole compounds are generally commercially available, such as from Sigma-Aldrich (Milwaukee, Wisconsin) and may be used without further purification. The azole compounds may be used in the pretreatment compositions in a wide range of amounts. Typically, the azole compound is used in an amount of from 0.005 to 50 g/L, preferably from 0.005 to 20 g/L, and more preferably from 0.01 to 15 g/L. The specific amount of azole compound depends upon the particular azole chosen and its solubility in the pretreatment composition.

Such pretreatment compositions may be alkaline or acidic and have a pH of from 1 to 14. The pH of the pretreatment compositions may be varied in order to increase the solubility of the azole compound. For example, the solubility of hydroxybenzotriazole can be increased by increasing the pH of the pretreatment composition.

A wide variety of organic and inorganic acids or organic and inorganic bases can be used to adjust the pH of the pretreatment compositions. Suitable inorganic acids include, but are not limited to: hydrochloric acid, hydrofluoric acid, fluoroboric acid, hydroiodic acid, periodic acid, phosphoric acid, sulfuric acid, and nitric acid. Suitable organic acids include, but are not limited to: alkylsulfonic acids, and arylsulfonic acids. Suitable inorganic bases include, but are not limited to, alkali metal hydroxides, alkali metal carbonates, and ammonium hydroxide. Suitable organic bases include, but are not limited to, tetraalkylammonium hydroxides, and amines. The acids and/or bases are typically present in the pretreatment compositions in an amount sufficient to provide the desired pH.

Preferably, the pretreatment compositions further include one or more chelating agents. Such chelating agents may be monodentate ligands, such as ammonia, cyanide, and pyridine, or multidentate ligands. Preferably, the chelating agents are the same as those used in the subsequent immersion silver plating bath. Other additional components may optionally be used in the pretreatment compositions. Such additional components include, but are not limited to, surfactants, metal ions, and the like. The surfactants may be anionic, cationic, nonionic or amphoteric. When a surfactant is used in the present pretreatment compositions, it is typically present in an amount of at least 0.001 wt%, more typically at least 0.005 wt%, and still more typically at least 0.01 wt%. Mixtures of surfactants may suitably be used.

When metal ions are present in the pretreatment compositions, it is preferred that they are the metal on which silver is to be deposited. For example, when silver is to be immersion deposited on copper, it is preferred that any metal ions present in the pretreatment composition are copper ions.

The amount of metal ions added to the pretreatment composition depends upon the particular metal that is less electropositive than silver, the particular azole compound used and the pH of the pretreatment composition. For example, when copper ions are present in the pretreatment composition, they are typically present in an amount up to 1 g/L, and more typically up to 0.05 g/L.

In general, the metal is contacted with the pretreatment composition for a period of time sufficient to increase the adhesion of a subsequently deposited layer of silver by immersion plating. Such period of time depends upon the particular metal and pretreatment composition used. Typically, a contact time of 1 second to 15 minutes is sufficient. Other suitable ranges of contact times include, without limitation, 5 seconds to 10 minutes, or 10 seconds to 5 minutes.

After the metal has been contacted with the pretreatment composition, it is optionally rinsed, such as with water, and then optionally dried. Such a rinsing step is preferred.

Silver is deposited according to the present invention by contacting a metal that is less electropositive than silver with the present immersion silver plating baths. Such contact may be by dipping, spraying, flood coating, and the like. When used in vertical plating equipment, the substrate is typically dipped in the present silver plating bath. When used in horizontal plating equipment, the substrate is typically contacted with the present silver plating bath by spraying or flooding.

The contact time of the metal with the immersion silver plating bath is that amount sufficient to deposit a desired thickness of silver. Typically, the contact time is from 10 seconds to 15 minutes, more typically from 20 seconds to 15 minutes, and still more typically from 30 seconds to 12 minutes.

The present immersion silver plating baths may be used at a variety of temperatures. Suitable temperatures include those in the range of from 10° to 70° C. Other suitable temperature ranges are from 15° to 60° C, and from 20° to 55° C.

The silver deposit typically has a thickness of 35 µin. (0.9 µm) or less, more typically 30 µin. (0.76 µm) or less, and even more typically 25 µin. (0.64 µm) or less. Following deposition, the silver layer may be rinsed such as with water. The silver layer may optionally be dried prior to subsequent processing steps.

In general, the metal that is less electropositive than silver is a metal layer on a substrate. A wide variety of substrates having a layer of a metal that is less electropositive than silver may be plated according to the present invention. Suitable substrates include, but are not limited to, jewelry, decorative objects, object d'art, semiconductor packaging, lead frames, solder bumps, metal powder, metal foils such as copper foil, and printed wiring board substrates. The present invention is particularly suited for depositing a solderable silver finish on a printed wiring board. Further, the present invention provides a method of manufacturing a printed wiring board including the steps of contacting a metal that is less electropositive than silver with an immersion silver plating bath containing one or more sources of silver ions, water and one or more carboxylic acid-substituted nitrogen-containing heterocyclic compounds to provide a layer of silver, wherein the bath has a pH of ≤ 4. Such a silver layer provides a solderable finish on the printed wiring board. Such solderable finishes are typically applied to a printed wiring board substrate having pads, through holes and a mask, such as a soldermask. In such a printed wiring board substrate, the exposed pads and through holes generally contain a layer of copper.

In yet another embodiment, the present invention is suitable for providing a printed wiring board substrate having exposed pads and/or through holes including a tin-silver alloy as the solderable finish. Thus, the present invention further provides a method for manufacturing a printed wiring board including the steps of: a) contacting a printed wiring board substrate having pads, through holes, soldermask and a layer of a metal that is less electropositive than tin with an immersion plating bath including a source of tin ions, water and a complexing agent, to form a tin deposit on the metal; b) then contacting the tin plated printed wiring board substrate with an immersion silver plating bath including one or more sources of silver ions, water and one or more carboxylic acid-substituted nitrogen-containing heterocyclic compounds, to form an immersion silver deposit on the tin deposit; and c) heating the silver-tin deposit to form a tin-silver alloy.

A wide variety of post-treatments may be used to treat the silver layer deposited according to the present invention. For example, it is well known that silver, such as in silver films, tarnishes upon prolonged exposure to air. Thus, in certain applications it is desirable to contact the freshly deposited silver layer with a tarnish inhibitor or anti-tarnish agent. Such silver tarnish inhibitors are well-known to those skilled in the art and include those described above. The silver deposit may be contacted with the tarnish inhibitor by any suitable means, such as, but not limited to, dipping, spraying, and flood coating. The use of a tarnish inhibitor subsequent to plating is not required, but may optionally be used. Other suitable post-treatments may also be advantageously used.

The present invention is particularly suitable for use in the manufacture of a wide variety of electronic devices in addition to printed wiring boards, such as lead frames, semiconductor packaging, and lead-free solder bumps on wafers, such as tin-silver and tin-copper-silver solders. The present invention is suitable for use in vertical or horizontal plating equipment.

The following examples are expected to further illustrate various aspects of the present invention, but are not intended to limit the scope of the invention in any aspect.

### Example 1

An immersion silver plating bath was prepared by combining 50 g/L picolinic acid and 1 g/L silver nitrate in water (final volume 1L). The pH of the bath was adjusted to 3, The bath temperature was adjusted to ca. 50 °C.

### Example 2

The procedure of Example 1 was repeated, except that another additive was added to the bath. These additives are listed in Table 1. The pH of these baths was again adjusted to 3. The bath temperature was adjusted to ca. 50 °C.

Copper panels (2 x 6 inches or 5 x 15 cm) were submerged in a commercially available acid cleaner to remove oxides and organic residues from the copper surface, followed by rinsing with water. The copper panels were next contacted with a commercially available sulfuric acid/hydrogen peroxide-based microetching composition to produce optimum copper surface uniformity and texture, followed by rinsing with water. After contact with the microetching composition, the copper panels were then submerged in either the silver plating bath of Example 1 or the plating bath containing additional additives of this example for 10 minutes.

The thickness of the resulting silver layer on the copper panels for each silver formulation was determined by X-ray fluorescence ("XRF") spectroscopy for a number of points on the panel and the data are reported as thickness ranges in Table 1. The picolinic acid and additive concentrations and the corresponding effect on silver plate thickness, obtained from XRF measurements, are illustrated below.

The silver plated copper panels were also evaluated to determine the adhesion of the silver layer. A 3 x 1 inch (7.6 x 2.5 cm) strip of transparent adhesive tape, Scotch 610 brand available from the 3M Company, Minneapolis, Minnesota, was applied to the surface of each of the silver coated copper panels. The tape was then removed from each panel. Silver deposits having poor adhesion, were readily removed by the tape were rated as "failed." Silver deposits having good adhesion were not removed by the tape were rated as "passed." The adhesion results are also reported in Table 1.

**Table 1**

| Immersion Silver Plating Bath | Additive | Amount of additive (g/L) | Thickness Range (µm) | Appearance | Tape Test |
|---|---|---|---|---|---|
| Example 1 | - | - | 0.091 - 0.18 | Bright | Passed |
| Example 2A | L-Glutamic Acid | 0.21 | 0.12 - 0.23 | Bright | Passed |
| | | 0.3 | 0.13 - 0.20 | Bright | Passed |
| | | 0.5 | 0.073 - 0.12 | Bright | Passed |
| Example 2B | Glycine | 0.1 | 0.10-0.22 | Bright | Passed |
| | | 0.4 | 0.17 - 0.27 | Bright | Passed |
| | | 1.0 | 0.19 - 0.31 | Bright | Passed |
| Example 2C | DL-Lysine | 0.01 | 0.071 - 0.20 | Bright | Passed |
| | | 0.05 | 0.12 - 0.24 | Bright | Passed |
| | | 0.1 | 0.12 - 0.28 | Bright | Passed |
| | | 0.5 | 0.38-0.52 | Bright | Passed |
| | | 1.5 | 0.40 - 0.57 | Bright | Passed |
| Example 2D | Mercaptodiacetic Acid | 0.1 | 0.19 - 0.27 | Bright | Passed |
| | | 0.25 | 0.14-0.22 | Bright | Passed |
| | | 0.30 | 0.26 - 0.42 | Bright | Passed |
| Example 2E | Imidazole | 0.25 | 0.053 - 0.12 | Bright | Passed |
| | | 0.50 | 0.049 - 0.13 | Bright | Passed |
| Example 2F | 4-Phenylimidazole | 0.15 | 0.30 - 0.45 | Bright | Passed |
| | | 0.25 | 0.16-0.39 | Bright | Passed |
| | | 0.30 | 0.058 - 0.10 | Bright | Passed |
| Example 2G | 2-Imidazolidone | 0.3 | 0.10 - 0.23 | Bright | Passed |
| | | 0.5 | 0.067 - 0.09 | Bright | Passed |
| | | 1.0 | 0.076 - 0.11 | Bright | Passed |
| Example 2H | 1,2,4-Triazolo[1,5- | .01 1 | 0.078-0.15 | Bright | Passed |
| | a]pyrimidine | | | | |
| | | .05 | 0.061 - 0.11 | Bright | Passed |
| | | 0.25 | 0.094 - 0.12 | Bright | Passed |
| | | 0.1 | 0.082 - 0.13 | Bright | Passed |
| Example 21 | 4-Amino-1,2,4-Triazole | 0.31 | 0.070 - 0.11 | Bright | Passed |
| Example 2J | 2-Imidazolidone | 0.3 | 0.10 - 0.23 | Bright | Passed |
| | | 0.5 | 0.067 - 0.089 | Bright | Passed |
| Example 2K | DL-Aspartic Acid | 0.05 | 0.090 - 0.26 | Bright | Passed |
| | | 0.10 | 0.10 - 0.17 | Bright | Passed |
| | | 0.25 | 0.068 - 0.10 | Bright | Passed |
| Example 2L | 5-Methoxyresorcinol | 0.01 | 0.087-0.16 | Bright | Passed |
| | | 0.02 | 0.13 - 0.27 | Bright | Passed |
| | | 0.05 | 0.083 - 0.13 | Bright | Passed |
| | | 0.1 | 0.088 - 0.12 | Bright | Passed |
| Example 2M | β-Alanine | 0.3 | 0.12 - 0.26 | Bright | Passed |
| | | 0.5 | 0.075 - 0.24 | Bright | Passed |
| | | 1.0 | 0.11 - 0.21 | Bright | Passed |
| Example 2N | Hydantoin | 0.3 | 0.22 - 0.32 | Bright | Passed |
| | | 0.5 | 0.13 - 0.24 | Bright | Passed |
| | | 1.0 | 0.18 - 0.27 | Bright | Passed |

From these data it can be seen that highly adherent, bright silver deposits were obtained.

### Example 3

The procedure of Example 1 was repeated, except that 0.01 and 0.05 g/L 1,2,4-triazolo[1,5-a]pyrimidine was also added to the compositions to provide Examples 3A and 3B. The pH of the baths was adjusted to 3. In each case, the bath temperature was adjusted to ca. 50 °C.

### Example 4

The procedure of Example 3 was repeated, except that 0.5 g/L glycine was added to each of the compositions to provide Examples 4A and 4B. These additives are listed in Table 2. The pH of these baths was again adjusted to 3. The bath temperature was adjusted to ca. 50 °C.

Copper panels (2 x 6 inches or 5 x 15 cm) were submerged in a commercially available acid cleaner to remove oxides and organic residues from the copper surface, followed by rinsing with water. The copper panels were next contacted with a commercially available sulfuric acid/hydrogen peroxide-based microetching composition to produce optimum copper surface uniformity and texture, followed by rinsing with water. After contact with the microetching composition, the copper panels were then submerged in either the silver plating baths of Example 3 or the plating baths of this example for 10 minutes.

The thickness of the resulting silver layer on the copper panels for each silver formulation was determined according to the procedure of Example 2 and the data are reported in Table 2. The picolinic acid and additive concentrations and the corresponding effect on silver plate thickness, obtained from XRF measurements, are illustrated below. The silver plated copper panels were also evaluated to determine the adhesion of the silver layer using the procedure of Example 2. The adhesion results are also reported in Table 2.

**Table 2**

| Immersion Silver Plating Bath | 1,2,4-Triazolo[1,5-a]pyrimidine (g/L) | Glycine (g/L) | Thickness Range (µm) | Appearance | Tape Test |
|---|---|---|---|---|---|
| Example 3A | 0.0 | 0 | 0.078 - 0.15 | Bright | Passed |
| Example 4A | 0.01 | 0.5 | 0.056 - 0.13 | Bright | Passed |
| Example 3B | 0.05 | 0 | 0.061-0.11 | Bright | Passed |
| Example 4B | 0.05 | 0.5 | 0.043 - 0.092 | Bright | Passed |

The above data clearly show that highly adherent, bright silver deposits were obtained.

### Example 5

The procedure of Example 1 was repeated, except that 0.02 and 0.05 g/L 5-methoxyresorcinol was also added to the compositions to provide Examples 5A and 5B. The pH of the baths was adjusted to 3. In each case, the bath temperature was adjusted to ca. 50 °C.

### Example 6

The procedure of Example 5 was repeated, except that 0.5 g/L glycine was added to each of the compositions to provide Examples 6A and 6B. These additives are listed in Table 3. The pH of these baths was again adjusted to 3. The bath temperature was adjusted to ca. 50 °C.

Copper panels (2 x 6 inches or 5 x 15 cm) were cleaned and microetched according to the procedure of Example 2. After contact with the microetching composition, the copper panels were then submerged in either the silver plating baths of Example 5 or the plating baths of this example for 10 minutes.

The thickness of the resulting silver layer on the copper panels for each silver formulation was determined by XRF spectroscopy according to the procedure of Example 2 and the data are reported in Table 3. The silver plated copper panels were also evaluated to determine the adhesion of the silver layer according to the procedure of Example 2. The adhesion results are also reported in Table 3.

**Table 3**

| Immersion Silver Plating Bath | Glycine (g/L) | 5-Methoxyresorcinol (g/L) | Thickness Range (µm) | Appearance | Tape Test |
|---|---|---|---|---|---|
| Example 5 A | 0 | 0.02 | 0.13 - 0.27 | Bright | Passed |
| Example 6A | 0.5 | 0.02 | 0.091-0.25 | Bright | Passed |
| Example 5B | 0 | 0.05 | 0.057-0.11 | Bright | Passed |
| Example 6B | 0.5 | 0.05 | 0.060 - 0.13 | Bright | Passed |

These data show that bright, highly adherent deposits were obtained.

### Example 7

The procedure of Example 1 was repeated, except that 0.10 g/L 1,2,4-triazolo[1,5-a]pyrimidine was also added to the composition to provide Example 7. The pH of the bath was adjusted to 3. The bath temperature was adjusted to ca. 50 °C.

### Example 8

The procedure of Example 7 was repeated, except that another additive was added to the bath. These additives are listed in Table 4. The pH of these baths was again adjusted to 3. The bath temperature was adjusted to ca. 50 °C.

Copper panels (2 x 6 inches or 5 x 15 cm) were cleaned and microetched according to the procedure of Example 2. The copper panels were next contacted with a commercially available sulfuric acid/hydrogen peroxide-based microetching composition to produce optimum copper surface uniformity and texture, followed by rinsing with water. After contact with the microetching composition, the copper panels were then submerged in either the silver plating bath of Example 7 or the plating bath containing additional additives of this example for 10 minutes.

The thickness of the resulting silver layer on the copper panels for each silver formulation was determined by XRF spectroscopy according to the procedure of Example 2 and the data are reported in Table 4. The silver plated copper panels were also evaluated to determine the adhesion of the silver layer according to the procedure of Example 2. The adhesion results are also reported in Table 4.

**Table 4**

| Immersion Silver Plating Bath | Additive | Amount of Additive (g/L) | Thickness Range (µm) | Appearance | Tape Test |
|---|---|---|---|---|---|
| Example 7 | - | - | 0.082 - 0.13 | Bright | Passed |
| Example 8A | L-Glutamic Acid | 0.11 | 0.083 - 0.12 | Bright | Passed |
| Example 8B | DL-Aspartic Acid | 0.05 | 0.075-0.14 | Bright | Passed |
| | | 0.10 | 0.081 - 0.11 | Bright | Passed |
| Example 8C | Mercaptodiacetic Acid | 0.3 | 0.14 - 0.28 | Bright | Passed |
| Example 8D | 2-Imidazolidone | 0.51 | 0.070 - 0.20 | Bright | Passed |
| Example 8E | DL-Lysine | 0.01 | 0.10 - 0.14 | Bright | Passed |
| | | 0.05 | 0.11-0.18 8 | Bright | Passed |
| | | 0.1 | 0.15 - 0.22 | Bright | Passed |
| | | 1.0 | 0.17 - 0.36 | Bright | Passed |
| Example 8F | β-Alanine | 0.1 | 0.082 - 0.10 | Bright | Passed |

These data clearly demonstrate that bright, highly adherent silver deposits were obtained.

### Example 9

The procedure of Example 1 was repeated, except that 0.01 1 g/L 1,2,4-triazolo[ 1,5-a]pyrimidine was also added to the composition to provide Example 9. The pH of the bath was adjusted to 3. The bath temperature was adjusted to ca. 50 °C.

### Example 10

The procedure of Example 9 was repeated, except that another additive was added to the bath. These additives are listed in Table 5. The pH of these baths was again adjusted to 3. The bath temperature was adjusted to ca. 50 °C.

Copper panels (2 x 6 inches or 5 x 15 cm) were cleaned and microetched according to the procedure of Example 2. After contact with the microetching composition, the copper panels were then submerged in either the silver plating baths of this example or the plating bath containing additional additives of Example 10 for 10 minutes.

The thickness of the resulting silver layer on the copper panels for each silver formulation was determined according to the procedure of Example 2 and the data are reported in Table 5. The silver plated copper panels were also evaluated to determine the adhesion of the silver layer according to the procedure of Example 2. The adhesion results are also reported in Table 5.

**Table 5**

| Immersion Silver Plating Bath | Additive | Amount of Additive (g/L) | Thickness Range (µm) | Appearance | Tape Test |
|---|---|---|---|---|---|
| Example 9 | - | - | 0.12-0.18 | Bright | Passed |
| Example 10A | L-Glutamic Acid | 0.11 | 0.081-0.15 | Bright | Passed |
| Example 10B | DL-Aspartic Acid | 0.10 | 0.11-0.17 | Bright | Passed |
| Example 10C | Mercaptodiacetic Acid | 0.10 | 0.16 - 0.30 | Bright | Passed |

These data show that bright, highly adherent silver deposits were obtained using the present immersion silver plating baths.

### Example 11

A number of silver plating baths were prepared by combining 1 g of silver nitrate and either 15 g, 25 g or 50 g of picolinic acid with 1 L of DI water. The pH of each bath was then adjusted using acid or base as appropriate to provide the desired pH. Each bath was then heated to ca. 50° C.

Copper panels (2x6 inches or 5x15 cm) were cleaned and microetched according to the procedure of Example 2. Each copper panel was then immersed in one of the plating baths. The copper panel were contacted with the plating baths for a set time, after which the panels were removed from the bath, rinsed with water and dried. The thickness of the resulting silver deposit on each panel was then determined according to the procedure of Example 2. The results are reported in Table 6.

**Table 6**

| pH | 15g/L Picolonic Acid | 25g/L Picolonic Acid | 50g/L Picolonic Acid |
|---|---|---|---|
| 3 | 0. 17 - 0.28 µm | 0.19 - 0.22 µm | 0.13 - 0.18 µm |
| 4 | 0.029 - 0.10 µm | 0.019 - 0.025 µm | 0.029 - 0.033 µm |
| 5 | 0.016-0.020 µm | 0.023 - 0.33 µm | 0.022 - 0.029 µm |
| 6 | 0.024 - 0.025 µm | 0.029 - 0.045 µm | 0.021 - 0.027 µm |
| 7 | 0.013 - 0.018 µm | 0.023 - 0.028 µm | 0.023 - 0.028 µm |

The above data clearly show that when picolinic acid is used as the sole complexing agent, much less silver is deposited when the pH of the bath is greater than 4.

### Example 12

A procedure of Example 1 except that the picolinic acid is replaced with one of the compounds in the amount shown in Table 7.

**Table 7**

| Compound | Amount (g/L) |
|---|---|
| Nicotinic acid | 45 |
| Isonicotinic acid | 40 |
| Quinolinic acid | 55 |
| Fusaric acid | 35 |
| Isonipecotic acid | 60 |
| Nipecotic acid | 65 |
| 2,6-pyridine dicarboxylic acid | 58 |
| Piperazine-2-carboxylic acid | 30 |
| Pyrrole-2-carboxylic acid | 35 |
| Pipecolinic acid | 50 |

### Example 13

Copper panels are cleaned and microetched according to the procedure of Example 2, and are then to be contacted with the plating baths of Example 12, to deposit a layer of silver.

## Claims

1. An immersion silver plating bath comprising one or more sources of silver ions, water and one or more carboxylic acid-substituted nitrogen-containing heterocyclic compounds, wherein the silver plating bath has a pH of less than or equal to 4.

2. The immersion silver plating bath of claim 1 wherein the bath is free of cyanide ions, ammonia and ammonium ions.

3. The immersion silver plating bath of any one of claims 1 to 2 wherein at least one of the carboxylic acid-substituted nitrogen-containing heterocyclic compound is chosen from picolinic acid, quinolinic acid, nicotinic acid, isonicotinic acid, fusaric acid, isonipecotic acid, nipecotic acid, 2,6-pyridine dicarboxylic acid, piperazine-2-carboxylic acid, pyrrole-2-carboxylic acid and piperolinic acid.

4. The immersion silver plating bath of any one of claims 1 to 2 wherein at least one of the carboxylic acid-substituted nitrogen-containing heterocyclic compound comprises a nitrogen-containing heterocyclic moiety selected chosen from pyridine, piperidine, piperazine, pyrrole, morpholine, pyrrolidine, triazole, and imidazole

5. The immersion silver plating bath of claim any one of claims 1 to 4 further comprising one or more thickness control agents.

6. The immersion silver plating bath of claim 5 wherein the thickness control agent is chosen from azoles, amino acids, hydroxy-substituted aromatic compounds, sulfur-containing compounds and hydantoins.

7. A method of depositing a layer of silver on a substrate comprising the step of contacting a substrate having a layer of a metal that is less electropositive than silver with the immersion silver plating bath of any one of claims 1 to 6.

8. The method of claim 7 wherein the substrate is a printed wiring board substrate.

9. The method of any one of claims 7 to 8 wherein the metal that is less electropositive than silver chosen from zinc, iron, tin, nickel, lead, copper or alloys of zinc, iron, tin, nickel, lead and copper.

10. A method of manufacturing a printed wiring board comprising the step of contacting a printed wiring board substrate having a layer of a metal that is less electropositive than silver with the immersion silver plating bath any one of claims 1 to 6.
